# Europäisches Patentamt
# European Patent Office
# Office européen des brevets

(19)

(11) Numéro de publication: **0 125 167**
**B1**

(12)

# FASCICULE DE BREVET EUROPÉEN

(45) Date de publication du fascicule du brevet:
**10.06.87**

(51) Int. Cl.⁴: **H 01 J 25/10, H 03 G 3/20**

(21) Numéro de dépôt: **84400847.4**

(22) Date de dépôt: **26.04.84**

(54) Klystron amplificateur de forte puissance apte à alimenter une charge variable.

(30) Priorité: **03.05.83 FR 8307362**

(43) Date de publication de la demande:
**14.11.84 Bulletin 84/46**

(45) Mention de la délivrance du brevet:
**10.06.87 Bulletin 87/24**

(84) Etats contractants désignés:
**DE GB IT**

(56) Documents cité:
**DE-A-1 766 741**
**FR-A-1 205 719**
**FR-A-2 280 211**
**GB-A-988 369**
**US-A-3 473 125**
**US-A-4 016 516**
**US-A-4 019 150**

**IRE TRANSACTIONS ON COMMUNICATIONS
SYSTEMS, vol. CS-10, no. 1, mars 1962, NEW YORK
(US), V.C. CHEWEY et al.: "Beam-controlled linear
klystron amplifiers for improved SSB efficiency",
pages 142-145.**

(73) Titulaire: **THOMSON- CSF, 173, Boulevard
Haussmann, F-75379 Paris Cedex 08 (FR)**

(72) Inventeur: **Faillon, Georges, THOMSON- CSF SCPI
173, bld Haussmann, F-75379 Paris Cedex 08 (FR)**
Inventeur: **Epsztein, Bernard, THOMSON- CSF
SCPI 173, bld Haussamnn, F-75379 Paris Cedex 08
(FR)**

(74) Mandataire: **Ruellan- Lemonnier, Brigitte,
THOMSON- CSF SCPI 19, avenue de Messine,
F-75008 Paris (FR)**

## Description

La présente invention concerne le domaine des générateurs de signaux hyperfréquence de forte puissance. Elle concerne plus particulièrement un klystron amplificateur pouvant fournir une puissance hyperiréquence très élevée et propre à alimenter une charge d'impédance variable.

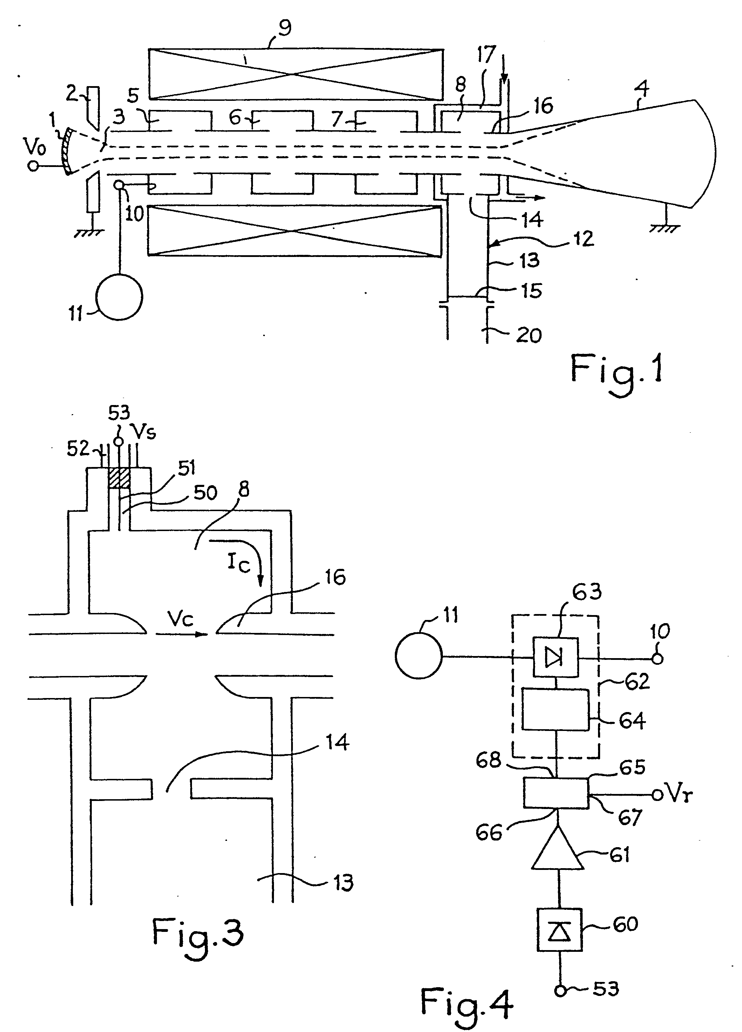

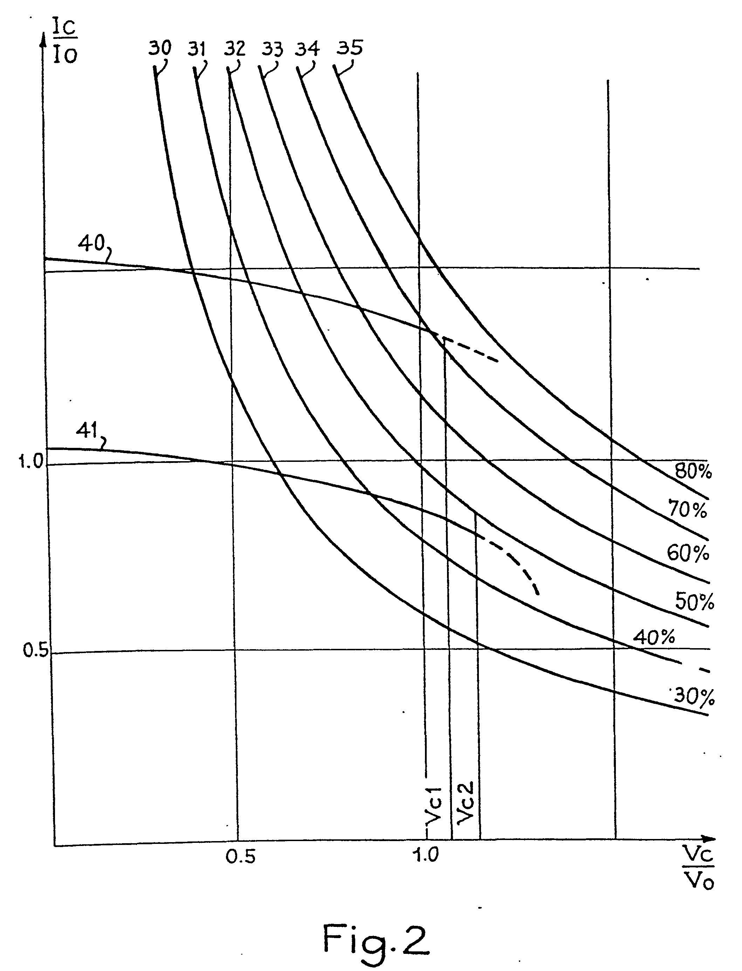

Pour mieux faire comprendre le problème posé et les solutions de l'art antérieur, on va d'abord décrire, en relation avec la figure 1, la structure schématique et le fonctionnement d'un klistron amplificateur et, en relation avec la figure 2, les performances qui peuvent être atteintes par un tel dispositif et les limitations existantes dans le cas ou il est appelé à fonctionner sur charge variable.

La figure 1 représente très schematiquement la structure classique d'un klystron amplificateur. Ce tube klystron comprend, à l'intérieur d'une enceinte à vide non représentée, un canon à électrons, dont on a représenté schématiquement la cathode 1 et l'anode accélératrice 2, qui engendre et projette un faisceau d'électrons 3 vers un collecteur 4 placé à l'autre extrémité du tube. Une succession de résonateurs à cavités est placée le long du faisceau de façon à interagir avec ce faisceau par leurs champs électriques respectifs. On distingue une cavité d'entrée 5, deux cavités intermédiaires 6 et 7 et une cavité de sortie 8. L'ensemble est autant que faire se peut entouré d'un enroulement magnétique 9 destiné à assurer la focalisation du faisceau. Le nombre de cavités intermédiaires est variable, elles sont éventuellement accordables, et leurs caractéristiques ainsi que celles les cavités d'entrée et de sortie sont déterminées par l'homme de l'art en vue des performances à obtenir. On pourra, pour leur réalisation, se reporter aux ouvrages classiques sur les klystrons amplificateurs.

Un circuit de couplage muni d'une borne 10 envoie à la cavité d'entrée le signal à amplifier issu d'un oscillateur hyperfréquence 11. Le champ électrique de cette cavité d'entrée 5 influence les électrons du faisceau dans le premier intervalle d'interaction en modulant en vitesse les électrons de ce faisceau. Les résonateurs 6 et 7 sont excités par le faisceau modulé et réagissent sur le faisceau électronique 3 en produisant un groupement favorable des électrons dans l'intervalle d'interaction du résonateur de sortie 8. Les électrons groupés passant dans l'intervalle d'interaction de la cavité de sortie 8 excitent cette cavité et de la puissance hyperfréquence est extraite de ce résonateur par l'intermédiaire d'un circuit de couplage de sortie 12 qui comprend, dans le mode de réalisation représenté, un embout 13 formant guide d'ondes dont la première extrémité débouche sur une ouverture 14 dans la paroi de la cavité 8 et dont l'autre extrémité est fermée de manière étanche au vide par une fenêtre 15 transparente au rayonnement électromagnétique hyperfréquence généré par le tube.

L'ensemble décrit précédemment (à l'exclusion de l'oscillateur 11) constitue un klystron amplificateur de puissance, que son fabricant livre aux utilisateurs en spécifiant des conditions d'utilisation et de refroidissement bien déterminées. Il est en effet clair, si l'on considère par exemple un klystron amplificateur de puissance destiné à fournir en continu un rayonnement électromagnétique d'une puissance de 500 kW à 500 MHz, que les conditions de refroidissement doivent être particulièrement bien observées. Il conviendra notamment de refroidir le collecteur 4 qui reçoit le faisceau électronique. Des circuits de refroidissement sont généralement prévus aussi pour les diverses cavités et en tout cas pour la cavité de sortie au niveau de laquelle il y a le plus de chances que des électrons divergent et viennent frapper les becs 16 de l'intervalle d'interaction. Ainsi, au moins cette cavité de sortie est généralement munie d'une chemise 17 dans laquelle est assurée une circulation d'un fluide de refroidissement, par exemple de l'eau désionisée.

A cet appareil, il reste a l'utilisateur à brancher le dispositif auquel il désire appliquer l'énergie hyperfréquence.

Pour ce faire, l'utilisateur relie a l'embout 13 un guide d'ondes 20 dirigeant l'énergie du klystron vers la charge, par exemple un plasma que l'on souhaite échauffer. Il est également imposé à l'utilisateur d'adapter la charge de sorte qu'aucune énergie ou seulement une très faible énergie (moins de 1% de l'énergie émise) ne soit renvoyée vers le klystron, c'est-à-dire que le rapport d'ondes stationnaire dans le guide 20 doit être sensiblement égal à 1. Dans le cas où la charge à exciter est une charge fixe stable, cette condition peut être remplie en sélectionnant convenablement le guide 20, son coefficient de couplage, ses dimensions, etc. Par contre, si la charge présente une impédance variable dans le temps, ce qui est par exemple le cas dans le chauffage micro-ondes ou le chauffage de plasma, le rapport d'ondes stationnaire peut beaucoup varier. Il peut s'élever à des valeurs aussi hautes que 3/1 ou même 4/1, avec des changements de phase difficiles à prévoir. En conséquence, on prévoit dans l'art antérieur, quand on couple un klystron de puissance sur une charge et que l'on veut faire fonctionner ce klystron dans sa zone de baut rendement, de disposer un circulateur entre le guide d'ondes de sortie 20 et la charge.

Un circulateur est, comme cela est bien connu, un dispositif permettant de sévier l'énergie hyperfréquence réfléchie par une charge pour qu'elle ne revienne pas sur son trajet incident. Il est généralement possible de fabriquer un circulateur fournissant des résultats satisfaisants et évitant les retours d'énergie vers le klystron émetteur. L'inconvénient de tels circulateurs réside essentiellement dans leur coût qui devient extrêmement élevé quand les puissances en jeu sont importantes. On cherche donc à éliminer ces circulateurs. Cela, comme cela sera exposé ci-après, ne peut se faire classiquement qu'au prix d'une utilisation du klystron dans une zone de faible rendement.

La figure 2 représente un graphique caractérisant le rendement d'un klystron. On a porté en abscisses la valeur VC/VO de la tension normalisée au niveau de l'intervalle d'interaction de la cavité de sortie, VC étant la tension aux bornes de cet intervalle d'interaction et VO la tension d'accélération du faisceau électronique 3. Les ordonnées indiquent la valeur IC/IO du courant normalisé dans la cavité de sortie, IC étant le courant dans cette cavité de sortie et IO le courant du faisceau électronique. Sur un tel graphique, des valeurs constantes du rapport IC.VC/IO.VO caractérisent des rendements donnés du tube et correspondent a des courbes en forme d'hyperboles. On a représenté sur la figure des courbes 30 à 35 caractéristiques de rendements allant de 30% à 80%. En fonction du couplage de la cavité de sortie, c'est-à-dire notamment des dimensions de l'ouverture 14, pour un tube donné, la valeur de VC peut être plus ou moins grande. Les courbes 40 et 41 indiquent comment varie IC en fonction de VC, c'est-à-dire en fonction du couplage de la cavité de sortie, pour des tubes de caractéristiques données. La courbe 40 correspond à un klystron de faible pervéance et la courbe 41 à un klystron de pervéance plus élevée.

On voit que pour augmenter le rendement, il est souhaitable d'augmenter autant que possible la valeur de la tension VC. Il existe toutefois une limite pour les valeurs maximales des tensions de crête VC. Cette limite est atteinte quand la tension de crête VC est sensiblement égale à la tension d'accélération VO du faisceau. En effet, si VC devient trop supérieur à VO, une partie au moins des électrons groupés risque d'être excessivement freinée et renvoyée dans la direction générale de la cathode. Ces électrons en retour seront généralement défocalisés et viendront frapper les parois internes du klystron, notamment au niveau des becs de la cavité de sortie qui risquent d'être fortement échauffés et même de fondre, ce qui entraîne la destruction du tube klystron. Dans le cas des courbes 40 et 41, on a indiqué les limites respectives VC1 et VC2 de la valeur maximale de la tension VC aux bornes de l'intervalle d'interaction permettant d'éviter ce phénomène.

Si la charge est parfaitement adaptée au klystron et que l'énergie réfléchie par cette charge soit pratiquement nulle, on pourra effectivement faire fonctionner le klystron dans ces zones de rendement maximal, c'est-à-dire pour les tensions VC1 et VC2 indiquées à la figure 2. Si maintenant, on utilise le klystron sans circulateur sur une charge variable et que l'énergie réfléchie puisse par exemple être de l'ordre de 10% de l'énergie émise (rapport d'ondes stationnaires égal à 2), ceci se traduit par l'apparition d'une tension V'C qui vient se superposer à la tension VC aux bornes de l'espace d'interaction, V'C étant de l'ordre de 30% de VC. La tension résultante risque alors de dépasser la limite tolérable et de conduire à la destruction du tube. Si les variations de l'impédance de charge ont un caractère aléatoire, le tube ne peut être protégé que par un régime permanent de fonctionnement à faible excitation, conduisant à un rendement faible en toutes circonstances.

Un objet de la présente invention est de remédier à cet inconvénient et de prévoir un klystron pouvant fonctionner sur charge variable dans les conditions de rendement optimales.

Pour atteindre cet objet ainsi que d'autres, la présente invention prévoit un klystron amplificateur de chauffage de charge variable comprenant dans sa cavité de sortie une sonde de détection du champ dans cette cavité. Le signal fourni par cette sonde est utilisé pour régler l'amplitude du signal hyperfréquence appliqué à la cavité d'entrée.

Ces objets, caractéristiques et avantages ainsi que d'autres de la présente invention seront exposés plus en détail dans la description suivante d'un mode de réalisation particulier faite en relation avec les figures jointes parmi lesquelles:
- les figures 1 et 2 destinées à illustrer l'état de la technique et à poser le problème que l'invention cherche à résoudre, ont été décrites précédemment,
- la figure 3 représente schématiquement la cavité de sortie d'un klystron selon la présente invention,
- la figure 4 représente sous forme de blocs un circuit adapté à un klystron selon la présente invention.

La présente invention résulte d'une étude approfondie du fonctionnement d'un klystron sur charge variable et d'une analyse détaillée des courbes de fonctionnement du type de celles représentées par la figure 2, analyse qui a déjà été esquissée précédemment.

Classiquement, les études sur de fonctionnement et le couplage de sortie d'un klystron se basaient essentiellement sur des explications associées au rapport d'ondes stationnaires apparaissant dans le guide d'ondes de sortie et sans analyser de façon détaillée ce qui se passe à l'intérieur de la cavité de sortie. On a vu qu'un rapport d'ondes stationnaires correspondait à l'apparition d'une tension parasite V'C aux bornes de l'espace d'interaction qui se superpose à la tension VC qui existerait en l'absence d'ondes réfléchies. Mais, notamment dans l'application au chauffage d'un plasma dans des machines du type "Tokamak", de nombreuses incertitudes existent sur cette tension V'C. Tout d'abord, sa phase est variable et non déterminée; d'autre part, même son amplitude ne peut pas être calculée à l'avance car des essais qui seraient faits à puissance réduite ne traduiraient en rien les phénomènes se produisant à pleine puissance quand le plasma est fortement chauffé. Etant donne cette ignorance que l'on a des conditions dans lesquelles fonctionnera effectivement le klystron, on est amené, comme on l'a vu précédemment, à réduire le rendement mais encore on le réduit beaucoup plus que nécessaire puisque l'on ne sait pas exactement quelles seront les conditions de fonctionnement et que l'on est obligé de prendre une marge de séecurité importante.

Pour éviter cet inconvénient et extraire du tube en toutes circonstances la plus grande puissance compatible avec l'impédance présentée par la charge, l'invention propose de limiter la tension régnant entre les becs de la cavité de sortie à la valeur qui prévaut lorsque le tube fonctionne de manière optimale sur une charge adaptée.

A cet effet, l'invention prévoit d'effectuer une mesure indirecte de la tension aux bornes de l'intervalle d'interaction de la cavité de sortie et d'utiliser le résultat de cette mesure pour asservir la puissance injectée par l'oscillateur 11 dans la cavité d'entrée 5 du klystron de manière que la tension aux bornes de l'intervalle d'interaction reste constante et égale à la valeur optimale VC1 ou VC2.

Pour évaluer la tension aux bornes de l'intervalle d'interaction, l'invention propose d'utiliser une sonde disposée dans la paroi de la cavité de sortie, fournissant pour un mode de résonance propre donné une indication proportionnelle à la tension recherchée. Ceci complique la fabrication du klystron puisque, comme le represente la figure 3, qui reprend de façon un peu moins schématique le dessin de la cavité de sortie avec les mêmes références que la figure 1, il est nécessaire de prévoir une ouverture 50 dans cette cavité de sortie pour glisser une sonde. Cette sonde peut être constituée de l'âme 51 d'une ligne coaxiale 52 ou de tout autre moyen équivalent tel qu'une boucle. Prévoir une ouverture dans la cavité de sortie est particulièrement délicat étant donné que, comme on l'a vu précédemment, cette cavité de sortie est généralement enfermée dans une chemise remplie d'eau. Néanmoins, cette complication de fabrication du klystron entraînera de façon générale une augmentation de coût bien inférieure au coût d'un circulateur. Le signal de sortie VS de la sonde selon la présente invention est disponible sur une borne 53.

La figure 4 représente à titre d'exemple comment ce signal VS peut être utilisé pour modifier le niveau du signal d'entrée reçu de l'oscillateur 11 par la borne 10 du coupleur de la cavité d'entrée. Ce signal à la borne 53 est d'abord redressé par un détecteur 60, par exemple une diode, puis est amplifié par un amplificateur à courant continu 61 pour être appliqué à un atténuateur 62 réglable par la tension continue de sortie de l'amplificateur 61, cet attenuateur étant interposé entre l'oscillateur 11 et la borne 10. L'atténuateur réglable comprend par exemple une diode PIN 63 dont la transmission dépend de la tension continue de polarisation qui lui est appliquée, cette tension de polarisation étant fournie par un modulateur 64 répondant au signal donné par l'amplificateur 61.

De plus, un dispositif comparateur 65, muni de trois bornes 66, 67 et 68, est interposé entre l'amplificateur 61 et l'atténuateur 62. Le dispositif 65 reçoit sur sa borne 66 la tension continue de l'amplificateur 61 et la restitue sur sa borne 68 à condition que ladite tension soit supérieure à la tension de référence Vr appliquée à sa borne 67; si ladite tension est au contraire inférieure a Vr, aucun signal n'apparaît à la borne 68 et l'atténuateur 62 est inactif.

La tension de référence Vr est déterminée en faisant fonctionner le klystron sur une charge adaptée dans les conditions optimales; la valeur a choisir pour Vr est la valeur de la tension alors présente sur la borne 66.

On insistera sur le fait que l'un des aspects fondamentaux de la présente invention réside dans l'application de l'idée selon laquelle le paramètre fondamental pour assurer un fonctionnement optimal d'un klystron de puissance sur charge variable est la tension effectivement présente aux bornes de l'intervalle d'interaction de la cavité de sortie et non pas le taux d'ondes stationnaires dans le coupleur de sortie de cette cavité (couramment un guide d'ondes). Ceci est d'autant plus vrai si la cavité de sortie du klystron comprend plusieurs sorties, et non pas une seule comme cela a été décrit et représenté précédemment. Alors, les taux d'ondes stationnaires présents dans ces diverses sorties peuvent être differents et l'on ne pourrait pas déduire de la mesure de l'un ou l'autre de ces taux d'ondes stationnaires l'énergie effectivement renvoyée sur le klystron et la modification resultante de la tension aux bornes de l'intervalle d'interaction.

La présente invention n'est pas limitée aux modes de réalisation qui ont été explicitement décrits; notamment, de nombreuses variantes pourront en être déduites par l'homme de l'art en tenant compte des connaissances acquises au jour de la présente demande.

## Revendications

1. Klystron amplificateur de puissance apte à alimenter une charge variable, caractérisé en ce qu'il comprend dans sa cavité de sortie (8) une sonde de détection (51) du champ dans cette cavité et en ce que le signal fourni par cette sonde est utilisé pour régler l'amplitude du signal hyperfréquence appliqué à la cavité d'entrée et amplifié par le klystron.

2. Klystron selon la revendication 1, caractérisé en ce que la sonde de détection est constituée de l'âme d'une ligne coaxiale insérée dans une ouverture et affleurant la surface interne de la cavité.

3. Klystron selon la revendication 1, caractérisé en ce que la sonde de détection est constituée d'une boucle de couplage électromagnétique.

4. Klystron selon la revendication 1, caractérisé en ce que le signal a la sortie (53) de la sonde (51) est appliqué à un atténuateur variable (62) inséré entre la source de signal haute fréquence (11) et l'entrée (10) de la cavité d'entrée par l'intermédiaire d'un détecteur (60), d'un amplificateur (61) et d'un comparateur (65).

5. Klystron selon la revendication 4, caractérisé en ce que l'atténuateur variable comprend une diode PIN (63) et un modulateur (64) modifiant la polarisation de cette diode.

## Patentansprüche

1. Leistungsverstärker-Klystron zur Speisung einer variablen Last, dadurch gekennzeichnet, daß es in seiner Ausgangskavität (8) eine Sonde (51) zur Detektion des Feldes in dieser Kavität aufweist und daß das von dieser Sonde gelieferte Signal zur Amplitudenregelung des an die Eingangskavität angelegten und vom Klystron verstärkten Mikrowellensignals verwendet wird.

2. Klystron nach Anspruch 1, dadurch gekennzeichnet, daß die Detektorsonde von der Seele einer Koaxialleitung gebildet wird, die in eine Öffnung hineinragt und in Höhe der Innen-Fläche der Kavität endet.

3. Klystron nach Anspruch 1, dadurch gekennzeichnet, daß die Detektorsonde von einer elektromagnetischen Koppelschleife gebildet wird.

4. Klystron nach Anspruch 1, dadurch gekennzeichnet, daß das Signal am Ausgang (53) der Sonde (51) an ein variables Dämpfungsglied (62) angelegt ist, das zwischen die Hochfrequenzquelle (11) und den Eingang (10) der Eingangskavität über einen Detektor (60), einen Verstärker (61) und einen Komparator (65) eingefügt ist.

5. Klystron nach Anspruch 4, dadurch gekennzeichnet, daß das variable Dämpfungsglied eine PIN-Diode (63) und einen Modulator (64) aufweist, durch den die Polarisation dieser Diode verändert wird.

## Claims

1. A high power amplifier klystron for feeding a variable load, characterized in that it includes in its output cavity (8) a detector probe (51) for detecting the field in this cavity, and that the signal supplied by this probe is used to adjust the amplitude of the microwave signal applied to the input cavity and amplified by the klystron.

2. A klystron according to claim 1, characterized in that the detector probe is constituted by the core of a coax line inserted into an opening and being flush with the inner surface of the cavity.

3. A klystron according to claim 1, characterized in that the detector probe is constituted by an electromagnetic coupling loop.

4. A klystron according to claim 1, characterized in that the signal available at the output (53) of the probe (51) is applied to a variable attenuator (62) inserted between the high frequency source (11) and the input (10) of the input cavity via a detector (60), an amplifier (61) and a comparator (65).

5. A klystron according to claim 4, characterized in that the variable attenuator comprises a PIN diode (63) and a modulator (64) modifying the polarisation of said diode.

0 125 167

Fig.1

Fig.3

Fig.4

1

Fig.2